# EUROPEAN PATENT SPECIFICATION

(11) **EP 1 754 805 B1**
(45) Date of publication and mention of the grant of the patent: **30.03.2011**
(21) Application number: 06254345.9
(22) Date of filing: 18.08.2006
(51) Int. Cl.: C25D 3/32, C25D 3/30

(54) **Tin electroplating solution and tin electroplating method**
Zinn galvanisches Bad und Zinn galvanisches Abscheidungsverfahren
Solution électrolytique de zinc et méthode d'électroplacage de zinc

(30) Priority: 19.08.2005 JP 2005238921
(43) Date of publication of application: 21.02.2007
(73) Proprietor: Rohm and Haas Electronic Materials LLC, Marlborough, MA 01752 (US)
(72) Inventor: Takizawa, Yasushi, Ageo-shi, Saitama 362-0047 (JP); Imanari, Masaaki, Misato-shi, Saitama 341-0026 (JP)
(74) Representative: Kent, Venetia Katherine

(56) References cited:
- EP-A- 0 889 147
- EP-A2- 0 490 575
- GB-A- 1 502 057
- US-A- 2 407 579
- US-A- 3 616 291
- US-A- 3 860 502

## Description

The present invention relates to a tin plating solution and tin electroplating method. In further detail, the present invention relates to a virtually lead-free tin electroplating solution that is used for joining electronic parts and the like, and a method for forming a tin film.

Tin-lead alloy plating has excellent bonding properties, low cost, electric properties, and solderability, and is therefore widely used in chips, crystal oscillators, lead frames, printed circuit boards, and other electronic parts that require electrical contact; and as an etching resist in steps used for the manufacture of semiconductor devices and printed substrates.

However, the use of lead has been restricted in recent years in order to protect the workplace environment and the natural environment, and lead-free plating baths have come to be regarded as a desirable substitute for tin-lead alloy plating materials. Tin-silver alloy plating, tin-copper alloy plating, and tin-bismuth alloy plating have been proposed as substitute materials. Nevertheless, difficulties are presented when handling tin-silver plating solutions due to electronic substitution of the metallic silver, as well as other problems. Tin-copper alloy plating has the drawback that the melting point thereof tends to increase and solder wettability decreases, and tin-bismuth alloy plating has the drawback in that the resulting film is brittle.

Tin plating solutions have also been investigated, but the resulting precipitate is rough, and problems are presented with regard to solder wettability. Gloss plating has been used in the past; however, the organic matter precipitate derived from the brightener in the glossy plating film clearly causes a reduction in solder joint strength and cracking. In other words, the use of an aldehyde compound or other organic brightener, or an ammonium salt or other amine-based brightener, results in the formation of a fine tin precipitate and improved solderability, but solder wettability deteriorates over time due to an increase in the amount of organic precipitate in the film. Moreover, a glossy plating film is generally brittle and not appropriate for use in lead frames and other applications where the plating film is required to be bent. Consequently, a demand has existed for semi-glossy plating in applications where gloss is not required.

Naphtholsulfonic acids have been used for years as an additive for tin electroplating solutions. For instance, in U.S. Pat. No. 2,407,579 it is disclosed that naphtholsulfonic acids or salts thereof; e.g.,. 2-naphthol-6-sulfonic acid, 2-naphthol-7-sulfonic acid, and 1-naphthol-4-sulfonic acid, can be added to fluorinated tin chloride baths consisting of tin chloride and an alkali fluoride and having a pH of 1 to 5. This patent does not disclose a combination of an organic acid bath and naphtholsulfonic acid.

An electrodeposition method is disclosed in JP (Kokoku) 49-16176 involving an electrodeposition bath wherein a complex salt of an aromatic sulfonic acid consisting of β-naphtholsulfonic acid and a metal compound is used as a base. This patent does not disclose the addition of β-naphtholsulfonic acid to an organic acid bath as an additive.

In JP (Kokai) 2002-17478 a tin-lead alloy plating bath is disclosed, consisting of a soluble stannous salt, a soluble lead salt, and one or more specific naphtholsulfonic acids. This patent does not disclose the use of 2-naphthol-7-sulfonic acid in a tin plating bath.
It is an object of the present invention to provide a tin electroplating solution and a tin electroplating method that do not involve the use of lead, yield a film whose appearance is uniform, and provide good solder wettability with parts that require electrical contact.

As a result of having conducted diligent research into lead-free tin electroplating solutions consisting of organic additives in order to achieve the above-mentioned object, the present inventors perfected the present invention by discovering that 2-naphthol-7-sulfonic acid and alkali salts thereof have selective capability when compared to other naphtholsulfonic acids. The plating solution of the present invention is capable of forming a tin film of good appearance, and of providing a good semi-glossy film with which the good solder wettability of the deposited tin film does not deteriorate, particularly after pressure cooker treatment.

In a first aspect, the present invention provides a tin electroplating solution consisting of one, two, or more organic acids, and 2-naphthol-7-sulfonic acid or salts thereof, and comprising virtually no lead ions.

In the present invention the organic acid is one, two, or more acids selected from the group consisting of alkane sulfonic acids and alkanol sulfonic acids.

In a second aspect, the present invention provides a plating solution comprising a tin salt of an organic acid as tin ions; one, two, or more acids selected from alkane sulfonic acids; one, two, or more compounds selected from the group consisting of 2-naphthol-7-sulfonic acid and salts thereof; one, two, or more antioxidants selected from the group consisting of substituted or unsubstituted dihydroxybenzene compounds; and one, two, or more nonionic surfactants; and consisting of virtually no lead ions.

In a third aspect, the present invention provides a method for electrodepositing a tin film on a substrate using any of the tin electroplating solutions described above.

In a fourth aspect, the present invention provides a method for manufacturing electronic components having a tin film on a substrate, including the step of electroplating a substrate using an acidic tin electroplating solution consisting of a tin salt of an organic acid; one, two, or more alkane sulfonic acids; one, two, or more compounds selected from a group consisting of 2-naphthol-7-sulfonic acid and an alkali salt thereof; one, two, or more antioxidants selected from a group consisting of substituted and unsubstituted dihydroxybenzene compounds; one, two, or more nonionic surfactants; and water.

The tin electroplating solution of the present invention is composed of stannous ions, an organic acid, and 2-naphthol-7-sulfonic acid or a salt thereof.

The abbreviations used throughout the present specification have the following denotations unless otherwise indicated: g = gram, mg = milligram; °C = degrees Celsius; min = minute, m = meter; cm = centimeter; L = liter; mL = milliliter; A = ampere, and dm² = square decimeter. All of the numeric ranges include the boundary values and can be combined in any order.

The terms "plating solution" and "plating bath" in the present specification have the same meaning and are used interchangeably. The terms "alkane" and "alkanol" refer to a linear or branched alkane or alkanol.

Examples of organic acid are acids selected from alkane sulfonic acids and alkanol sulfonic acids or salts thereof. Preferred alkane sulfonic acids or alkanol sulfonic acids include substituted or unsubstituted alkane sulfonic acids and alkanol sulfonic acids. Examples include methanesulfonic acid, ethanesulfonic acid, propanesulfonic acid, 2-hydroxyethane-1-sulfonic acid, 2-hydroxypropane-1-sulfonic acid, and 1-hydroxypropane-2-sulfonic acid. Methanesulfonic acid is particularly preferred. One or a mixture of two or more of these acids can be used.

The organic acid content of the plating solution is at least the stoichiometric equivalent of the bivalent tin ions present in the plating bath. For instance, the free acid content in the plating bath is 30 g/L to 500 g/L, particularly 50 g/L to 300 g/L, and ideally 70 g/L to 250 g/L.

Stannous ions are bivalent ions. A variety of compounds can be used as long as they are capable of supplying such ions to the plating bath. Examples include stannous salts of sulfuric acid, hydrochloric acid, methanesulfonic acid, citric acid, malic acid, or other organic acids. An example of a preferred source of stannous ions is a tin salt selected from the above-mentioned organic acids. Particularly preferred examples are compounds selected from an alkane sulfonic acid stannous salt or an alkanol sulfonic acid stannous salt. It is generally preferred that a tin salt of an organic acid be used in the plating solution. One or a mixture of two or more of these stannous salts can be used.

The stannous ion content of the plating bath in terms of stannous ions is for instance, 10 g/L to 150 g/L, preferably 30 g/L to 120 g/L, and particularly 50 g/L to 100 g/L.

2-naphthol-7-sulfonic acid can be used as a free acid or in the form of a salt. Examples of ideal salts are soluble salts of potassium, sodium, ammonium, tin, or the like. Potassium and sodium salts are preferred, with sodium 2-naphthol-7-sulfonate being particularly preferred. One or a mixture of two or more of these salts can be used.

The amount of 2-naphthol-7-sulfonic acid or salt thereof contained in the plating bath is, e.g., 0.01 g/L to 20 g/L, preferably 0.2 g/L to 10 g/L, and particularly 0.3 g/L to 5 g/L.

A surfactant can be used as needed in the plating solution of the present invention. A variety of surfactants can be used, but nonionic surfactants are more suitable. Examples of preferred nonionic surfactants include polyoxyethylene lauryl ether, polyethylene glycol, polyoxyethylene alkyl ether, polyoxyethylene polyoxypropylene glycol, polyoxyethylene nonylphenyl ether, polyoxyethylene polyoxypropylene alkylamine, and polyoxyalkylene adducts of ethylene diamine, with tetrakis-(polyoxyalkylene)ethylene diamine or polyoxyethylene polyoxypropylene (C₈-C₁₈) alkyl amines being particularly preferred. Such surfactants can be obtained commercially from Lion Akzo Co., Ltd. under such brand names as Ethopropomeen C18/18, or from Asahi Denka Co., Ltd. under the brand name Adekanol TR-704.

The appropriate surfactant concentration of the plating bath is, e.g., 0.01 g/L to 50 g/L, preferably 0.1 g/L to 20 g/L, and particularly 1 g/L to 15 g/L.

An antioxidant can be used as needed in the plating solution of the present invention. An antioxidant is used in order to prevent oxidation of the tin ions from divalent to tetravalent form, with examples including hydroquinone, catechol, resorcinol, fluoroglycine, pyrogallol, and hydroquinone sulfonic acid, as well as salts thereof.

The plating bath should have an antioxidant concentration of, e.g., 0.01 g/L to 10 g/L, preferably 0.1 g/L to 5.0 g/L, and particularly 0.5 g/L to 2.0 g/L.
The tin plating solution of the present invention is adjusted to the acidic range. The preferred pH of the plating bath is, e.g., less than 7, and preferably 3 or less. Brighteners, lubricants, conductors, anode dissolving agents, or other conventional additives can be added to the present invention as needed.

An example of an especially preferred composition for the tin electroplating solution of the present invention is an acidic tin electroplating solution consisting of a tin salt of an organic acid; one, two, or more alkane sulfonic acids; one, two, or more compounds selected from a group consisting of 2-naphthol-7-sulfonic acid and alkali salts thereof; one, two, or more antioxidants selected from substituted or unsubstituted dihydroxybenzene compounds; one, two, or more nonionic surfactants; and water.

The composition of the present invention consists of virtually no lead. "Consists of virtually no lead" indicates that no lead is added to the plating bath as an additional component, but does not rule out the possibility of a lead component being present in the compound components. Moreover, the composition of the present invention preferably contains no metallic stabilizers, such as bismuth.

The method for electroplating using the plating solution of the present invention can be a conventional method. The concentration of each component of the plating solution is selected as needed according to the plating method; e.g., barrel plating, through-hole plating, rack plating, or high-speed continuous plating.

Electroplating using the electroplating solution of the present invention can be performed at a plating bath temperature of, e.g., 10° to 65°C, and preferably room temperature to 50°C.

The cathode current density can be selected from within a range of, e.g., 0.01 to 100 A/dm², and preferably 0.05 to 70 A/dm².

It is not necessary to stir the plating bath during plating, but a method such as stirrer-assisted stirring or pump-assisted circulation can also be selected.
As will be evident from the Working Examples, specific naphtholsulfonic acids wherein hydroxyl groups and sulfonic acid groups bond at a specific position in the naphthalene ring, and specifically 2-naphthol-7-sulfonic acid or an alkali salt thereof, show an obvious effect in comparison to other naphtholsulfonic acid or salts thereof. In other words, a tin film that is fine and not brittle will precipitate from the plating solution of the present invention, with the precipitated film showing good solder wettability.

The plating solution of the present invention can be used for a variety of plated articles as a substitute for conventional tin plating and tin-lead alloy plating for soldering or etching resists. The article to be plated should have a conductive component capable of being electroplated, and includes composites made from conductive materials such as copper or nickel and insulating materials such as ceramics, glass, plastics, ferrite, and the like. Before being electroplated, the articles can be pretreated by a conventional method depending on the material used. According to the electroplating of the present invention, tin films can be deposited on the surface of conductive materials on substrates or a variety of electronic parts, including chip capacitors, chip resistors, and other chip parts, crystal oscillators, pumps, connector pins, lead frames, printed circuit boards, and the like.

### Working Example 1

A tin plating solution was prepared with the following composition.

| | |
|---|---|
| Stannous methanesulfonate (as tin ions) | 70 g/L |
| Methanesulfonic acid (as a free acid) | 175 |
| Sodium 2-naphthol-7-sulfonate | 0.5 |
| Polyoxyethylene polyoxypropylene (C₈-C₁₈) alkyl amine | 10 |
| Potassium hydroquinone sulfonate | 2 |
| Distilled water | Remainder |

A Hull cell test was performed using a plating bath with the above-mentioned composition and a 6.7 cm × 10 cm copper sheet, with electrolysis performed at 5 A × 1 minute and a bath temperature of 50°C, and stirring by cathode vibration at a rate of 4 to 6 m/minute. Table 1 shows the results obtained by macroscopically evaluating the appearance of the plating film; i.e., precipitation anomalies, uniformity, and gloss.

The term "precipitation anomalies" generally refers to unplated areas that tend to form where the current is low, and precipitation regions known as "bums" or "burnt deposits" that tend to form where current density is too high. "Uniformity" means that the state of a precipitated film surface was observed in the current density region generally used by the electroplating method.

### Comparative Example 1

A Hull cell test was conducted under the same conditions as in Working Example 1 using a plating bath wherein the 0.5 g/L of sodium 2-naphthol-7-sulfonate in Working Example 1 was substituted for 0.5 g/L of sodium 2-naphthol-6-sulfonate. The appearance of the plating film was observed macroscopically, with the results shown in Table 1.

### Comparative Example 2

A Hull cell test was conducted under the same conditions as in Working Example 1 using a plating bath wherein the 0.5 g/L of sodium 2-naphthol-7-sulfonate in Working Example 1 was substituted for 0.5 g/L of disodium 2-naphthol-3,6-sulfonate. The appearance of the plating film was observed macroscopically, with the results shown in Table 1.

### Comparative Example 3

A Hull cell test was conducted under the same conditions as in Working Example 1 using a plating bath wherein the 0.5 g/L of sodium 2-naphthol-7-sulfonate in Working Example 1 was substituted for 0.5 g/L of disodium 1-naphthol-3,6-sulfonate. The appearance of the plating film was observed macroscopically, with the results shown in Table 1.

### Working Example 2

A Hull cell test was conducted under the same conditions as in Working Example 1 using a plating bath wherein the amount of sodium 2-naphthol-7-sulfonate in Working Example 1 was changed from 0.5 g/L to 0.2 g/L. The appearance of the plating film was observed macroscopically, with the results shown in Table 1.

### Working Example 3

A Hull cell test was conducted under the same conditions as in Working Example 1 using a plating bath wherein the amount of sodium 2-naphthol-7-sulfonate in Working Example 1 was changed from 0.5 g/L to 0.3 g/L. The appearance of the plating film was observed macroscopically, with the results shown in Table 1.

### Comparative Example 4

A Hull cell test was conducted under the same conditions as in Working Example 1 using a plating bath wherein the amount of disodium 2-naphthol-3,6-disulfonate added in Comparative Example 2 was changed from 0.5 g/L to 1.0 g/L. The appearance of the plating film was observed macroscopically, with the results shown in Table 1.

### Comparative Example 5

A Hull cell test was conducted under the same conditions as in Working Example 1 using a plating bath wherein the 0.5 g/L of sodium 2-naphthol-7-sulfonate in Working Example 1 was changed to 0.2 g/L of 2-naphthol. The appearance of the plating film was observed macroscopically, with the results shown in Table 1.

### Comparative Example 6

A hull cell test was conducted under the same conditions as in Working Example 1 with a plating bath wherein the 0.5 g/L of sodium 2-naphthol-7-sulfonate in Working Example 1 was changed to 10 mg/L of salicylic aldehyde. The appearance of the plating film was observed macroscopically, with the results shown in Table 1.

**Table 1**

| | Plating film appearance |
|---|---|
| Working Example 1 | Some precipitation anomalies, uniform surface, semi-glossy |
| Comparative Example 1 | Some precipitation anomalies, irregular surface, semi-glossy |
| Comparative Example 2 | Some precipitation anomalies, irregular surface, semi-glossy |
| Comparative Example 3 | Some precipitation anomalies, irregular surface, semi-glossy |
| Working Example 2 | Some precipitation anomalies, virtually uniform surface, semi-glossy |
| Working Example 3 | Some precipitation anomalies, uniform surface, semi-glossy |
| Comparative Example 4 | Some precipitation anomalies, uniform surface, dull to semi-glossy |
| Comparative Example 5 | Some precipitation anomalies, irregular surface, semi-glossy |
| Comparative Example 6 | Many precipitation anomalies, irregular surface, irregular gloss |

The plating films obtained in the working examples all exhibited some precipitation anomalies but were uniform and had a semi-glossy appearance. By contrast, the film obtained in Comparative Example 4 had some precipitation anomalies and a uniform appearance, but its gloss was diminished compared to those of the working examples. A uniform film could not be obtained in the other comparative examples.

### Electrolysis test

Two liters of each plating bath in Working Example 1 and Comparative Example 4 were prepared and electrolysis was performed with each plating bath under a current of 10 A for four hours. A tin plating film was formed as in Working Example 1 using the bath before electrolysis and the bath after electrolysis, with the appearance thereof being macroscopically evaluated.

Although no changes in appearance were seen with the plating film formed from the plating baths before and after electrolysis when the plating bath in Working Example 1 was used, the plating film obtained when the plating bath in Comparative Example 4 was used was dull after electrolysis.

### Solder wettability test

Two liters of each plating bath used in Working Example 1 and Comparative Example 4 were prepared, and a tin plating film of 10 µm was deposited on a copper-lead frame. The bath temperature was 27°C, stirring was performed by vibrating the cathode at a rate of 4 m/minute and also with a stirrer, and the current density was varied between 5 and 40 A/dm².

Each of the resulting tin plating films was subjected to a moisture-resistance test at 105°C and 100% RH for eight hours (PCT treatment (105°C, 100% RH, 8 hours)), and the solder wettability of the plating films after the moisture-resistance test was evaluated by measuring the zero cross time in accordance with the meniscograph method using a solder checker. The measurement conditions were as shown below:
Zero cross time measurement
Solder cell: Sn/Pb = 63/37
Bath temperature: 235°C
Immersion depth: 1 mm
Immersion speed: 10 mm/second
Immersion time: 5 seconds
Flux: Inactive rosin

Table 2 shows the results obtained in the above-mentioned tests.

**Table 2**

| Plating current density (A/dm²) | Solder wettability after moisture resistance test | |
|---|---|---|
| | Working Example 1 | Comparative Example 4 |
| 5 | 1.6 seconds | 5 seconds or longer |
| 10 | 1.4 seconds | 5 seconds or longer |
| 15 | - | 5 seconds or longer |
| 20 | 1.2 seconds | 5 seconds or longer |
| 25 | - | 5 seconds or longer |
| 30 | 1.1 seconds | 5 seconds or longer |
| 35 | - | Not measured |
| 40 | 1.7 seconds | Not measured |

The tin plating time was adjusted for each current density so that the plating film thickness would be 10 µm. A uniform film could not be obtained at a current density of 35 A/dm² or 40 A/dm² with the plating solution of Comparative Example 4; therefore, the test was not conducted.

The plating film obtained in Working Example 1 showed excellent results when its solder wettability after the moisture-resistance test was compared to that of Working Example 4. These data clearly show that the plating solution of the present invention has excellent solder wettability.

Lead, which has been problematic, is not used; therefore, the tin electroplating solution of the present invention is very safe. Moreover, the plating solution is easily handled because plating is not conducted with an alloy, and a uniform plating film can be obtained. The resulting tin plating film is uniform, semi-glossy, and has excellent solder wettability; and is therefore useful as a joining material.

## Claims

1. A tin electroplating solution comprising one or more compounds for supplying stannous ions, one or more organic acids selected from the group consisting of alkane sulfonic acid and alkanol sulfonic acid and one or more of 2-naphthol-7-sulfonic acid and salts thereof.

2. The tin electroplating solution of claim 1, further comprising one or more of antioxidants and surfactants.

3. The tin electroplating solution of claim 1, wherein the one or more of 2-naphthol-7-sulfonic acid and salts thereof are included in the electroplating solution in amounts of 0.01 g/L to 20 g/L.

4. The tin electroplating solution of claim 1, wherein the electroplating solution contains virtually no lead ions.

5. A method for electroplating a tin film on a substrate comprising:
a) providing a tin electroplating solution comprising one or more compounds for supplying stannous ions, one or more organic acids selected from the group consisting of alkane sulfonic acid and alkanol sulfonic acid and one or more of 2-naphthol-7-sulfonic acid and salts thereof;
b) contacting the substrate with the tin electroplating solution; and
c) plating the tin film on the substrate.

6. The method of claim 5, wherein the one or more or 2-naphthol-7-sulfonic acid and salts thereof are included in the electroplating solution in amounts of 0.01 g/L to 20 g/L.

7. The method for electroplating a tin film on a substrate of claim 5, further comprising a step of subjecting the substrate to an activation treatment prior to contacting the substrate with the electroplating solution.

## Patentansprüche

1. Zinn-Elektroplattierungslösung, umfassend eine oder mehrere Verbindungen zum Zuführen von Zinn(II)-Ionen, eine oder mehrere organische Säuren, ausgewählt aus der Gruppe, bestehend aus Alkansulfonsäure und Alkanolsulfonsäure, und eine oder mehrere von 2-Naphthol-7-sulfonsäure und Salzen davon.

2. Zinn-Elektroplattierungslösung gemäß Anspruch 1, weiter umfassend ein oder mehrere von Antioxidantien und grenzflächenaktiven Mitteln.

3. Zinn-Elektroplattierungslösung gemäß Anspruch 1, wobei die eine oder mehrere von 2-Naphthol-7-sulfonsäure und Salzen davon in der Elektroplattierungslösung in Mengen von 0,01 g/L bis 20 g/L enthalten ist bzw. sind.

4. Zinn-Elektroplattierungslösung gemäß Anspruch 1, wobei die Elektroplattierungslösung nahezu keine Bleiionen enthält.

5. Verfahren zum Elektroplattieren eines Zinnfilms auf einem Substrat, umfassend:
a) das Bereitstellen einer Zinn-Elektroplattierungslösung, umfassend eine oder mehrere Verbindungen zum Zuführen von Zinn (II)-Ionen, eine oder mehrere organische Säuren, ausgewählt aus der Gruppe, bestehend aus Alkansulfonsäure und Alkanolsulfonsäure, und eine oder mehrere von 2-Naphthol-7-Sulfonsäure und Salzen davon,
b) das Inkontaktbringen des Substrats mit der Zinn-Elektroplattierungslösung, und
c) das Plattieren des Zinnfilms auf dem Substrat.

6. Verfahren gemäß Anspruch 5, wobei die eine oder mehrere von 2-Naphthol-7-sulfonsäure und Salzen davon in der Elektroplattierungslösung in Mengen von

7. Verfahren zum Elektroplattieren eines Zinnfilms auf einem Substrat gemäß Anspruch 5, weiter umfassend den Schritt des Unterwerfens des Substrats einer Aktivierungsbehandlung vor dem Inkontaktbringen des Substrats mit der Elektroplattierungslösung.

## Revendications

1. Solution de dépôt électrolytique d'étain comprenant un ou plusieurs composés pour fournir des ions stanneux, un ou plusieurs acides organiques choisis dans le groupe consistant en un acide alcanesulfonique et un acide alcanolsulfonique et un ou plusieurs de l'acide 2-napthol-7-sulfonique et de ses sels.

2. Solution de dépôt électrolytique d'étain selon la revendication 1 comprenant en outre un ou plusieurs d'antioxydants et de tensioactifs.

3. Solution de dépôt électrolytique d'étain selon la revendication 1 où le un ou plusieurs de l'acide 2-naphtol-7-sulfonique et de ses sels sont inclus dans la solution de dépôt électrolytique en des quantités de 0,01 g/L à 20 g/L.

4. Solution de dépôt électrolytique d'étain selon la revendication 1 où la solution de dépôt électrolytique ne contient virtuellement pas d'ions plomb.

5. Procédé pour le dépôt électrolytique d'un film d'étain sur un substrat comprenant :
a) la fourniture d'une solution de dépôt électrolytique d'étain comprenant un ou plusieurs composés pour fournir des ions stanneux, un ou plusieurs acides organiques choisis dans le groupe consistant en un acide alcanesulfonique et un acide alcanolsulfonique et un ou plusieurs de l'acide 2-napthol-7-sulfonique et de ses sels ;
b) la mise en contact du substrat avec la solution de dépôt électrolytique d'étain ; et
c) le dépôt électrolytique du film d'étain sur le substrat.

6. Procédé selon la revendication 5 où le un ou plusieurs de l'acide de 2-naphtol-7-sulfonique et de ses sels sont inclus dans la solution de dépôt électrolytique en des quantités de 0,01 g/L à 20 g/L.

7. Procédé pour le dépôt électrolytique d'un film d'étain sur un substrat selon la revendication 5 comprenant en outre une étape d'exposition du substrat à un traitement d'activation avant la mise en contact du substrat avec la solution de dépôt électrolytique.
